# EUROPEAN PATENT APPLICATION

(11) **EP 4 576 160 A1**
(43) Date of publication of application: **25.06.2025**
(21) Application number: 23855031.3
(22) Date of filing: 03.07.2023
(51) Int. Cl.: H01J 37/32, H05H 1/00

(54) **VIEWPORT FOR PLASMA MONITORING, PLASMA GENERATOR COMPRISING SAME, AND PLASMA MONITORING METHOD**

(30) Priority: 18.08.2022 KR 20220103103
(71) Applicant: Korea Institute of Fusion Energy, Daejeon 34133 (KR)
(72) Inventor: KIM, Jong Sik, Gunsan-si Jeollabuk-do 54138 (KR); KIM, Yong Hyun, Gunsan-si Jeollabuk-do 54142 (KR); KIM, Dae Chul, Gunsan-si Jeollabuk-do 54101 (KR); KIM, Young Woo, Hwaseong-si Gyeonggi-do 18443 (KR); PARK, Jong Bae, Gunsan-si Jeollabuk-do 54086 (KR); SHIN, Jong Hyun, Gunsan-si Jeollabuk-do 54161 (KR)
(74) Representative: Appleyard Lees IP LLP
(86) International application number: PCT/KR2023/009305
(87) International publication number: WO 2024/039060

(57) **Abstract**

Disclosed are a viewport for plasma monitoring, a plasma generator comprising same, and a monitoring method. The viewport for plasma monitoring may comprise a transparent substrate and a transparent detection unit formed thereon and be arranged on the outside of a plasma chamber such that the transparent substrate enables observation of the inside of the plasma chamber while the transparent detection unit measures the electromagnetic field generated by plasma in the plasma chamber.

## Description

### FIELD

The present disclosure relates to a viewport for monitoring plasma electromagnetic field characteristics, a plasma generator including the same, and a plasma monitoring method.

### DESCRIPTION OF RELATED ART

In order to use plasma for manufacturing a semiconductor device and a flat panel display (FPD), it is essential to control plasma through monitoring of a state of the plasma to manage a process yield and a process result. A chamber which is a plasma generator, is generally provided with a viewport for visually observing plasma. A purpose of the present disclosure is to configure an electrical circuit capable of monitoring the state of plasma on the surface of a viewport or inside the viewport while preserving the function of visually observing plasma through such a viewport.

### DISCLOSURE

### TECHNICAL PURPOSE

A purpose of the present disclosure is to provide a viewport for plasma monitoring capable of observing the inside of a plasma chamber and measuring an electromagnetic field from plasma.

Another purpose of the present disclosure is to provide a plasma generator including the viewport for plasma monitoring.

Still another purpose of the present disclosure is to provide a plasma monitoring method for observing the inside of the plasma chamber using the viewport for plasma monitoring and for measuring an electromagnetic field from plasma.

### TECHNICAL SOLUTION

In one aspect, the present disclosure provides a viewport for plasma monitoring, comprising: a transparent substrate; and a transparent sensing unit formed on the transparent substrate and including: a transparent electrode; and a flat coil.

In an embodiment, the viewport for plasma monitoring may be formed outside the plasma chamber and may be configured to observe the inside of the plasma chamber through the transparent substrate, and at the same time, to measure an electromagnetic field generated from the plasma generated in the plasma chamber through the transparent sensing unit.

In an embodiment, the transparent sensing unit may include indium tin oxide (ITO).

In an embodiment, the viewport for plasma monitoring may further includes a PCB (printed circuit board) disposed outside the transparent substrate and having a circuit printed thereon, wherein the circuit is configured to process a signal of the electromagnetic field measured using the transparent sensing unit.

In an embodiment, the circuit included in the printed circuit board may include one or more members selected from a group including a low pass filter, a high pass filter, and a resonance filter.

In an embodiment, the circuit included in the printed circuit board may derive one or more frequencies selected from the group including a plasma frequency, a plasma operation frequency, and a plasma instability frequency of the plasma.

In another aspect, the present disclosure provides a plasma generator comprising: a plasma chamber having a hollow defined in at least one surface thereof, wherein the plasma chamber is configured to generate plasma therein; and a viewport unit including: a transparent substrate formed to cover the hollow; and a transparent sensing unit formed on the transparent substrate and outside the plasma chamber, wherein the transparent sensing unit includes a transparent electrode and a flat coil.

In an embodiment, the transparent sensing unit may include indium tin oxide (ITO).

In an embodiment, the viewport for plasma monitoring may further includes a PCB (printed circuit board) disposed outside the transparent substrate and having a circuit printed thereon, wherein the circuit is configured to process a signal of the electromagnetic field measured using the transparent sensing unit.

In an embodiment, the circuit included in the printed circuit board may include one or more members selected from a group including a low pass filter, a high pass filter, and a resonance filter.

In an embodiment, the circuit included in the printed circuit board may derive one or more frequencies selected from the group including a plasma frequency, a plasma operation frequency, and a plasma instability frequency of the plasma.

According to still another aspect, the present disclosure provides a plasma monitoring method including observing an inside of a plasma chamber through the viewport for plasma monitoring as described above; and measuring an electromagnetic field generated from plasma generated in the plasma chamber through the viewport for plasma monitoring.

### TECHNICAL EFFECT

The viewport for plasma monitoring according to an embodiment of the present disclosure may observe the inside of the plasma chamber and monitor the electromagnetic environment at the same time.

The plasma generator according to an embodiment of the present disclosure may be configured so that the inside thereof may be observed through the viewport for plasma monitoring, and an electromagnetic environment thereof may be measured through the viewport for plasma monitoring.

The plasma monitoring method according to an embodiment of the present disclosure provides a method for measuring the electromagnetic environment of the plasma generator while observing the inside of the plasma generator.

### BRIEF DESCRIPTION OF DRAWINGS

FIG. 1 is a view schematically showing a viewport for plasma monitoring according to an embodiment of the present disclosure.
FIG. 2 is a front view, a plan view, or a side view illustrating one surface of a plasma generator according to an embodiment of the present disclosure.
FIG. 3 is a flowchart illustrating an embodiment of a plasma monitoring method according to an embodiment of the present disclosure.

### DETAILED DESCRIPTIONS

Hereinafter, embodiments of the present disclosure will be described in detail with reference to the accompanying drawings. The present disclosure may be subjected to various changes and may have various forms. Thus, particular embodiments will be illustrated in the drawings and will be described in detail herein. However, this is not intended to limit the present disclosure to a specific disclosed form. It should be understood that the present disclosure includes all modifications, equivalents, and replacements included in the spirit and technical scope of the present disclosure. While describing the drawings, similar reference numerals are used for similar components. In the accompanying drawings, the dimensions of the structures are shown in an enlarged view for clarity of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "including", "include", and "including" when used in this specification, specify the presence of the stated features, integers, operations, elements, and/or components, but do not preclude the presence or addition of one or more other features, integers, operations, elements, components, and/or portions thereof.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

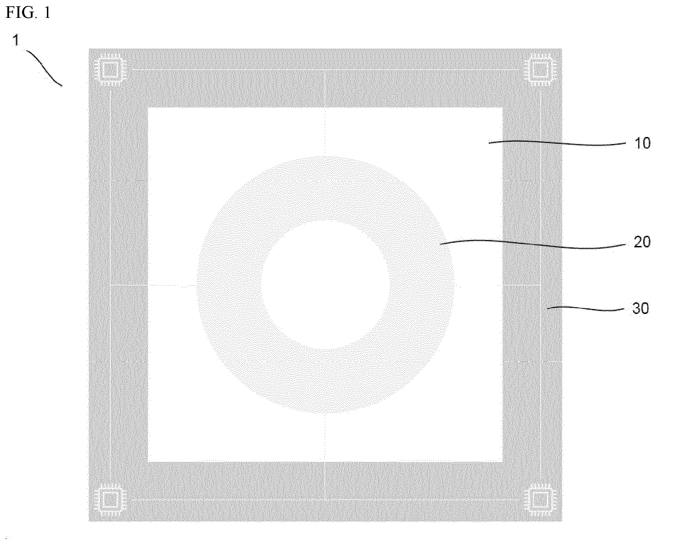

FIG. 1 is a view schematically showing a viewport for plasma monitoring according to an embodiment of the present disclosure.

Referring to FIG. 1, a viewport 1 for plasma monitoring according to an embodiment of the present disclosure may include a transparent substrate 10; and a transparent sensing unit 20 formed on the transparent substrate 10 and including a transparent electrode and a flat coil.

The transparent substrate 10 includes a transparent material, and is a member through which visible light having transmitted through the transparent substrate 10 can substantially transmit. In the context of the present specification, 'transparency' refers to a property in which an entirety or a portion of incident visible light thereto may transmit through, and refers to a property having transmittance enough such that the naked eye, a device, or a circuit can recognize and process an entirety or a significant portion of visible information related to a material, an object, or a phenomenon located on the other side of the transparent member. In an embodiment, when the transparent substrate 10 is formed outside the plasma chamber, the inside of the plasma chamber may be observed through the transparent substrate 10.

The transparent sensing unit 20 includes a transparent conductive material such that visible light substantially transmits through the transparent sensing unit 20 which has conductivity. In particular, the transparent sensing unit 20 is a member having a conductive path formed to react to an electromagnetic environment of plasma generated in the plasma chamber on an side opposite to a viewport including the surrounding. In the context of this specification, 'conductivity' refers to a property capable of providing a significant level of an electrical movement path. In an embodiment, an electromagnetic field generated from the plasma generated in the plasma chamber may be measured through the transparent sensing unit 20. In an embodiment, properties of an electromagnetic field, such as an intensity of an induced magnetic field and an intensity of an induced electric field which is generated from the plasma generated in the plasma chamber may be measured through the transparent sensing unit 20. Therefore, as long as a type of a material constituting the transparent sensing unit 20 is a material having substantially transparent properties as described above and having conductivity enough to perform a function of measuring the electromagnetic field, the type of the material constituting the transparent sensing unit 20 is not particularly limited. In an embodiment, the transparent sensing unit may include Indium tin oxide (ITO).

The viewport 1 for plasma monitoring according to an embodiment of the present disclosure simultaneously performs the functions of the transparent substrate 10 and the transparent sensing unit 20 to achieve the purpose of the present disclosure. In an embodiment, the viewport 1 for plasma monitoring may be formed outside the plasma chamber and may be used to observe the inside of the plasma chamber through the transparent substrate 10, and at the same time, the transparent sensing unit 20 may measure the electromagnetic field generated from the plasma generated in the plasma chamber.

The addition of an additional member to the viewport 1 for plasma monitoring according to an embodiment of the present disclosure is not limited. Referring to FIG. 1, in an embodiment, the viewport 1 for plasma monitoring according to an embodiment of the present disclosure may further include a printed circuit board (PCB) 30 formed outside the transparent substrate 10 and having a circuit printed thereon capable of processing a signal of the electromagnetic field measured by the transparent sensing unit 20.

The printed circuit board 30 may be a member including a substrate on which the circuit has been previously formed. When the circuit printed on the substrate of the printed circuit board 30 is formed on the substrate, the electromagnetic field signal from the transparent sensing unit 20 may be processed by the circuit. As long as the above-described function is performed by the circuit, the type of the circuit, the material of the circuit, the function of the circuit, the method in which the circuit is formed, and the like are not particularly limited.

In an embodiment, the circuit included in the printed circuit board 30 may include one or more members selected from a group including a low pass filter, a high pass filter, and a resonance filter. In an embodiment, the circuit included in the printed circuit board 30 may derive one or more frequencies selected from the group including a plasma frequency, a plasma operation frequency, and a plasma instability frequency of the plasma.

As described above, the viewport for plasma monitoring according to an embodiment of the present disclosure may observe the inside of the plasma chamber and at the same time derive an electromagnetic environment.

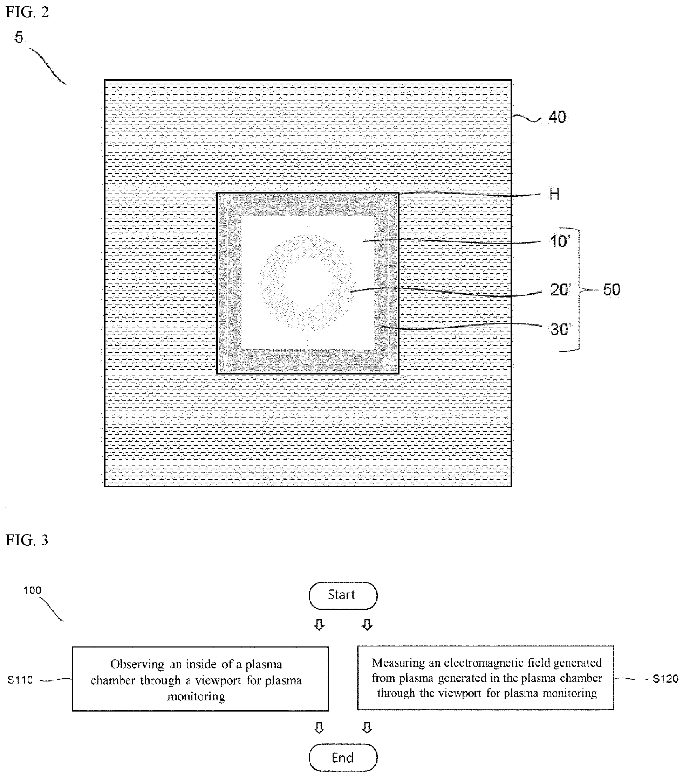

FIG. 2 is a front view, a plan view, or a side view illustrating one surface of a plasma generator according to an embodiment of the present disclosure.

Referring to FIG. 2, a plasma generator 5 according to an embodiment of the present disclosure may include a plasma chamber 40 having a hollow H defined in at least one surface thereof and configured to generate the plasma therein, and a viewport 50 including a transparent substrate 10' formed to cover the hollow H and a transparent sensing unit 20' formed on the transparent substrate 10' and outside the plasma chamber 40.

The hollow H defined in at least one surface of the plasma generator 5 is used to observe the inside of the plasma chamber 40. In the context of the present specification, the term "hollow" may mean a configuration formed to be surrounded with a member and perforated to extending through both opposite surfaces of the member. The hollow H may be formed in at least one surface of the plasma generator 5, that is, at least one of an upper surface, a lower surface, and a side surface thereof. FIG. 2 shows one surface of the plasma generator 5 in which the hollow H is formed. Thus, FIG. 2 may be a front view, a plan view, or a side view.

The description of the components of the viewport 1 for plasma monitoring according to the embodiment of the present disclosure may be applied to the description of the same or similar components of the viewport 50 of the plasma generator 5 according to the embodiment of the present disclosure. Therefore, the purpose of the present disclosure may be achieved by applying the viewport 50 for plasma monitoring capable of observing the inside of the plasma chamber 40 through at least the hollow H while the above-described viewport 1 for plasma monitoring acts the viewport 50 of the plasma generator 5.

Further, in an embodiment, the transparent sensing part 20' may include indium tin oxide (ITO). In an embodiment, the viewport 50 may further include a printed circuit board (PCB) 30' formed outside the transparent substrate 10' and having a circuit printed thereon capable of processing a signal of an electromagnetic field measured by the transparent sensing unit 20'. In an embodiment, the circuit included in the printed circuit board 30' may include one or more members selected from the group including a low pass filter, a high pass filter, and a resonance filter. In an embodiment, the circuit included in the printed circuit board 30' may derive one or more frequencies selected from the group including a plasma frequency, a plasma operation frequency, and a plasma instability frequency of the plasma.

As described above, the inside of the plasma generator according to the embodiment of the present disclosure may be observed through the viewport for plasma monitoring, and an electromagnetic environment of the generator may be derived through the viewport for plasma monitoring.

FIG. 3 is a flowchart illustrating an embodiment of a plasma monitoring method according to an embodiment of the present disclosure.

Referring to FIG. 3, a plasma monitoring method 100 according to an embodiment of the present disclosure may include observing the inside of the plasma chamber through the viewport for plasma monitoring in S110, and measuring an electromagnetic field generated from the plasma generated in the plasma chamber through the viewport for plasma monitoring in S120. In an embodiment, the plasma monitoring method 100 according to an embodiment of the present disclosure may include simultaneously performing the observation of the inside of the plasma chamber through the viewport for plasma monitoring in S110 and measuring the electromagnetic field generated from the plasma generated in the plasma chamber through the viewport for plasma monitoring in S120. In an embodiment, observing the inside of the plasma chamber through the viewport for plasma monitoring in S110 may include observing the inside of the plasma chamber through the viewport for plasma monitoring according to the above-described embodiment of the present disclosure. In an embodiment, measuring the electromagnetic field generated from the plasma generated in the plasma chamber through the viewport for plasma monitoring in S120 may be measuring the electromagnetic field generated from the plasma generated in the plasma chamber through the viewport for plasma monitoring according to the above-described embodiment of the present disclosure.

As described above, the plasma monitoring method according to the embodiment of the present disclosure provides a method for observing the inside of the plasma generator and deriving the electromagnetic environment at the same time.

Hereinafter, an embodiment of the present disclosure will be described in detail. However, the embodiments as described below are only some embodiments of the present disclosure, and the scope of the present disclosure is not limited to the following embodiments.

### Manufacture of Viewport for Plasma Monitoring

A viewport for plasma monitoring is manufactured. A printed circuit board PCB is disposed outside a transparent substrate including a transparent material. A flat coil and a capacitor made of ITO are formed on the transparent substrate to form a resonance circuit suitable for plasma monitoring which in turn is connected to the PCB substrate located outside the transparent substrate. A BNC port is installed on the PCB substrate so that the BNC port may be connected to a monitorable instrument such as an oscilloscope. Thus, the viewport is configured to measure the plasma operating frequency or harmonic frequency.

### Operation of Plasma generator

A closed plasma chamber was constructed, and the fabricated viewport for plasma monitoring was attached to one side of the plasma chamber. The inside of the plasma chamber was observed through the viewport, the observation result was analyzed using optical equipment, and the electromagnetic environment thereof was derived using a function of the ITO transparent sensing unit and the printed circuit board. In particular, the plasma operating frequency and harmonic frequency were derived.

Although described above with reference to the preferred embodiments of the present disclosure, those skilled in the art will understand that the present disclosure may be variously modified and changed within the scope not departing from the spirit and scope of the present disclosure described in the following patent claims.

### Reference numerals

1: Viewport for plasma monitoring
10, 10': Transparent substrate
20, 20': Transparent sensing unit
30, 30': Printed circuit board
5: Plasma generator
H: Hollow
40: Plasma chamber
50: Viewport
100: Plasma monitoring method

## Claims

1. A viewport for plasma monitoring, the viewport comprising:
a transparent substrate; and
a transparent sensing unit formed on the transparent substrate, wherein the transparent sensing unit includes a transparent electrode, and a flat coil,
wherein the viewport is disposed outside a plasma chamber,
wherein the viewport is configured to observe an inside of the plasma chamber through the transparent substrate, and at the same time, to measure an electromagnetic field generated from plasma generated in the plasma chamber using the transparent sensing unit.

2. The viewport for plasma monitoring of claim 1, wherein the transparent sensing unit includes indium tin oxide (ITO).

3. The viewport for plasma monitoring of claim 1, wherein the viewport further comprises a PCB (printed circuit board) disposed outside the transparent substrate and having a circuit printed thereon, wherein the circuit is configured to process a signal of the electromagnetic field measured using the transparent sensing unit.

4. The viewport for plasma monitoring of claim 3, wherein the circuit included in the printed circuit board includes at least one member selected from the group consisting of a low pass filter, a high pass filter, and a resonance filter.

5. The viewport for plasma monitoring of claim 4, wherein the circuit included in the printed circuit board derives one or more frequencies selected from the group including a plasma frequency, a plasma operation frequency, and a plasma instability frequency of the plasma.

6. A plasma generator comprising:
a plasma chamber having a hollow defined in at least one surface thereof, wherein the plasma chamber is configured to generate plasma therein; and
a viewport unit including:
a transparent substrate formed to cover the hollow; and
a transparent sensing unit formed on the transparent substrate and outside the plasma chamber, wherein the transparent sensing unit includes a transparent electrode and a flat coil.

7. The plasma generator of claim 6, wherein the transparent sensing unit includes indium tin oxide (ITO).

8. The plasma generator of claim 6, wherein the viewport unit further includes a PCB (printed circuit board) disposed outside the transparent substrate and having a circuit printed thereon, wherein the circuit is configured to process a signal of the electromagnetic field measured using the transparent sensing unit.

9. The plasma generator of claim 8, wherein the circuit included in the printed circuit board includes at least one member selected from the group consisting of a low pass filter, a high pass filter, and a resonance filter.

10. The plasma generator of claim 9, wherein the circuit included in the printed circuit board derives one or more frequencies selected from the group including a plasma frequency, a plasma operation frequency, and a plasma instability frequency of the plasma.

11. A plasma monitoring method comprising:
observing an inside of a plasma chamber through the viewport for plasma monitoring according to one of claims 1 to 5; and
measuring an electromagnetic field generated from plasma generated in the plasma chamber through the viewport for plasma monitoring.
